# EUROPEAN PATENT APPLICATION

(11) **EP 4 817 389 A1**
(43) Date of publication of application: **07.10.2026**
(21) Application number: 24914625.9
(22) Date of filing: 04.01.2024
(51) Int. Cl.: A01D 34/00

(54) **BODY, ROBOT AND ROBOT SYSTEM**

(71) Applicant: Aiper Global Pte. Ltd., Singapore 409051 (SG)
(72) Inventor: WANG, Yang, Shenzhen, Guangdong 518000 (CN)
(74) Representative: Osterhoff, Utz
(86) International application number: PCT/CN2024/070657
(87) International publication number: WO 2025/145395

(57) **Abstract**

A body includes: a housing (11), wherein a sealed cavity (111) is provided in the housing (11), and a heat dissipation channel (112) is further provided on the housing (11), the heat dissipation channel (112) communicating with an external environment and being independent of the sealed cavity (111); a control board (12), provided in the sealed cavity (111), wherein an Al chip (121) is provided on the control board (12); a vision module (13), provided on the housing (11), wherein at least part of the vision module (13) is located in the sealed cavity (111), and the vision module (13) is electrically connected to the Al chip (121); and a heat sink (14), provided on the housing (11), wherein part of the heat sink (14) is located in the sealed cavity (111), another part of the heat sink (14) is located in the heat dissipation channel (112), and the heat sink (14) is configured to dissipate heat from the Al chip (121). A robot includes the body. A robot system includes the body. The body, the robot, and the robot system configured in this manner have the sealed cavity for mounting the control board independent of the heat dissipation channel, and dissipate heat from the Al chip through the heat sink partly provided in the sealed cavity and partly provided in the heat dissipation channel, thereby solving the technical problem in the related art that sealing requirements and heat dissipation requirements of a lawn mower robot conflict with each other.

## Description

### TECHNICAL FIELD

The present application relates to the technical field of intelligent robots, and more specifically, to a body, a robot, and a robot system.

### BACKGROUND

Intelligent lawn mower robots are devices that facilitate mowing of lawns and vegetation. They have features such as automatic traveling, intelligent obstacle avoidance, and autonomous operation within a certain range. An intelligent lawn mower robot can complete mowing in a set lawn area according to an input instruction without manual operation, thereby reducing labor intensity for a user.

Intelligent lawn mower robots operate in complex outdoor environments filled with weeds, and therefore need waterproofing, moisture-proofing, and heat dissipation functions. Waterproofing and moisture-proofing are mainly achieved by a sealed structure; however, better sealing reduces air circulation and weakens heat dissipation. Because lawn mower robots are small and have highly integrated electronic components and related devices, especially an artificial intelligence (AI) chip integrated on a circuit board, massive computation may cause the temperature of the AI chip to rise rapidly. If heat dissipation is poor, the circuit board and electronic components may fail, affecting normal operation of the intelligent lawn mower robot and even burning out the circuit board and the components.

### SUMMARY

An objective of the present application is to provide a body, a robot, and a robot system, so as to solve the technical problem in the related art that sealing requirements and heat dissipation requirements of an intelligent lawn mower robot conflict with each other.

Based on this, in a first aspect, the present application provides a body. The body includes a housing, a control board, a vision module, and a heat sink. A sealed cavity is provided in the housing, and a heat dissipation channel is further provided on the housing. The heat dissipation channel communicates with an external environment and is independent of the sealed cavity. The control board is provided in the sealed cavity and is provided with an AI chip. The vision module is provided on the housing, is at least partially located in the sealed cavity, and is electrically connected to the AI chip. The heat sink is provided on the housing; part of the heat sink is located in the sealed cavity, another part of the heat sink is located in the heat dissipation channel, and the heat sink is configured to dissipate heat from the AI chip.

In a second aspect, the present application further provides a robot, including the body described above.

In a third aspect, the present application further provides a robot system. The robot system includes a first body and at least one second body detachably connectable to the first body, and the first body is the body described above.

The body, the robot, and the robot system provided by the present application have at least the following beneficial effects: the sealed cavity for mounting the control board and the heat dissipation channel are provided independently on the housing, and the heat sink is provided on the housing. Part of the heat sink is located in the sealed cavity and is configured to receive heat generated by the AI chip on the control board. The heat can be conducted in the heat sink, and another part of the heat sink is located in the heat dissipation channel and exchanges heat with external airflow, thereby conducting heat from the AI chip to the external environment and dissipating heat from the AI chip.

### BRIEF DESCRIPTION OF THE DRAWINGS

To more clearly illustrate the technical solutions in the embodiments of the present application, the drawings used in the description of the embodiments or the related art are briefly introduced below. Obviously, the drawings described below are merely some embodiments of the present application. Those of ordinary skill in the art may obtain other drawings based on these drawings without creative effort.
FIG. 1 is a first three-dimensional structural schematic view of a body according to an embodiment of the present application.
FIG. 2 is a second three-dimensional structural schematic view of the body according to an embodiment of the present application, in which a decorative shell is omitted.
FIG. 3 is a third three-dimensional structural schematic view of the body according to an embodiment of the present application, in which the decorative shell and an upper shell are omitted.
FIG. 4 is a fourth three-dimensional structural schematic view of the body according to an embodiment of the present application, in which the decorative shell and the upper shell are omitted and an assembly manner of a vision module and a bottom shell is shown.
FIG. 5 is an enlarged schematic view of a mounting structure of the vision module in FIG. 4.
FIG. 6 is a fifth three-dimensional structural schematic view of the body according to an embodiment of the present application, in which a mounting position of a rear decorative shell is shown.
FIG. 7 is a cross-sectional structural schematic view of the body according to an embodiment of the present application.
FIG. 8 is another cross-sectional structural schematic view of the body according to an embodiment of the present application.
FIG. 9 is a first three-dimensional structural schematic view of a button module in the body according to an embodiment of the present application.
FIG. 10 is a second three-dimensional structural schematic view of the button module in the body according to an embodiment of the present application.
FIG. 11 is a cross-sectional structural schematic view of the button module in the body according to an embodiment of the present application.
FIG. 12 is an enlarged structural schematic view of a portion of the vision module in FIG. 7.
FIG. 13 is a structural schematic view of the vision module in the body according to an embodiment of the present application from one viewing angle.
FIG. 14 is a structural schematic view of the vision module in the body according to an embodiment of the present application from another viewing angle.
FIG. 15 is a structural schematic view of a mounting base in FIG. 13.
FIG. 16 is an assembly structural schematic view of the bottom shell and part of the decorative shell in the body according to an embodiment of the present application.
FIG. 17 is a structural schematic view of a front decorative shell in the body according to an embodiment of the present application.
FIG. 18 is a structural schematic view of a middle decorative shell in the body according to an embodiment of the present application.
FIG. 19 is a structural schematic view of the rear decorative shell in the body according to an embodiment of the present application.
FIG. 20 is a structural schematic view of a housing in the body according to an embodiment of the present application, in which an assembly manner of the upper shell and the bottom shell is shown.
FIG. 21 is a structural schematic view of the bottom shell in the body according to an embodiment of the present application.
FIG. 22 is a structural schematic view of a front side of a control board in the body according to an embodiment of the present application.
FIG. 23 is a structural schematic view of a back side of the control board in the body according to an embodiment of the present application.
FIG. 24 is a three-dimensional structural schematic view of a robot according to an embodiment of the present application.

Reference signs in the drawings:
1. first body; 2. second body; 3. walking mechanism; 11. housing; 12. control board; 13. vision module; 14. heat sink; 15. button module; 16. positioning module; 110. heat-insulating cavity; 111. sealed cavity; 112. heat dissipation channel; 113. first mounting opening; 114. second mounting opening; 115. bottom shell; 116. upper shell; 117. decorative shell; 118. handle; 119. speaker; 120. programming port; 121. AI chip; 122. base board; 123. core board; 124. communication board; 131. first mounting portion; 132. second mounting portion; 133. lens; 134. slot; 135. abutment rib; 136. mounting cavity; 137. first sealing ring; 141. contact plate; 142. heat dissipation fins; 151. mounting housing; 152. function button assembly; 153. button board; 154. first side; 155. second side; 157. annular rib; 158. support member; 159. elastic sheet; 1171. front decorative shell; 1172. middle decorative shell; 1173. rear decorative shell; 1151. third mounting opening; 1152. receiving groove; 1153. second sealing ring; 1521. emergency stop switch; 11711. viewing window; 11731. louver.

### DETAILED DESCRIPTION OF THE EMBODIMENTS

To make the technical problems, technical solutions, and beneficial effects of the present application clearer, the present application is further described in detail below with reference to the accompanying drawings and embodiments. It should be understood that the specific embodiments described herein are merely used to explain the present application, and are not intended to limit the present application.

It should be noted that when a component is referred to as being "fixed to" or "provided on" another component, it may be located directly or indirectly on the other component. When a component is referred to as being "connected to" another component, it may be connected directly or indirectly to the other component. Terms such as "upper," "lower," "left," "right," "front," "rear," "vertical," "horizontal," "top," "bottom," "inner," and "outer" indicate orientations or positions based on the drawings, are merely for ease of description, and should not be construed as limiting the technical solution. The terms "first" and "second" are used merely for ease of description, and should not be construed as indicating or implying relative importance or implicitly specifying a quantity of technical features. Unless otherwise expressly and specifically defined, "a plurality of" means two or more.

Intelligent robots, especially outdoor intelligent robots, operate in complex outdoor environments exposed to sun and rain, and therefore generally need waterproofing, moisture-proofing, and heat dissipation functions. Waterproofing and moisture-proofing are mainly achieved by a sealed structure; however, better sealing reduces air circulation and weakens heat dissipation.

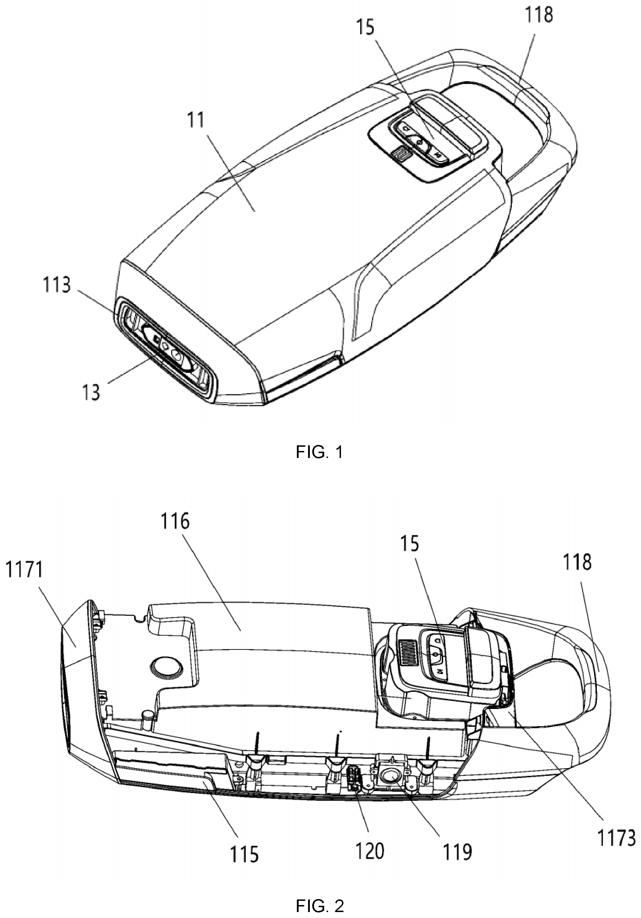

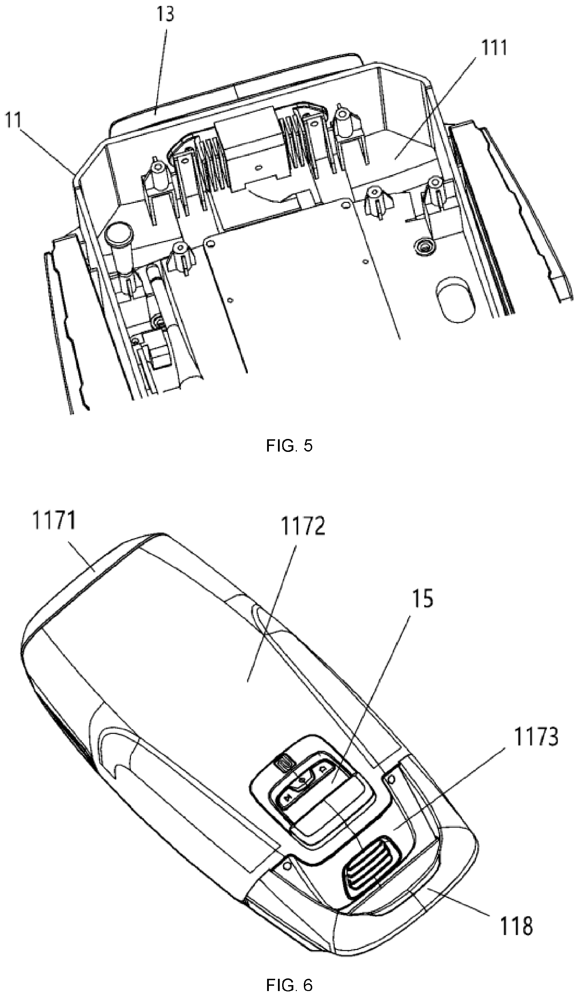

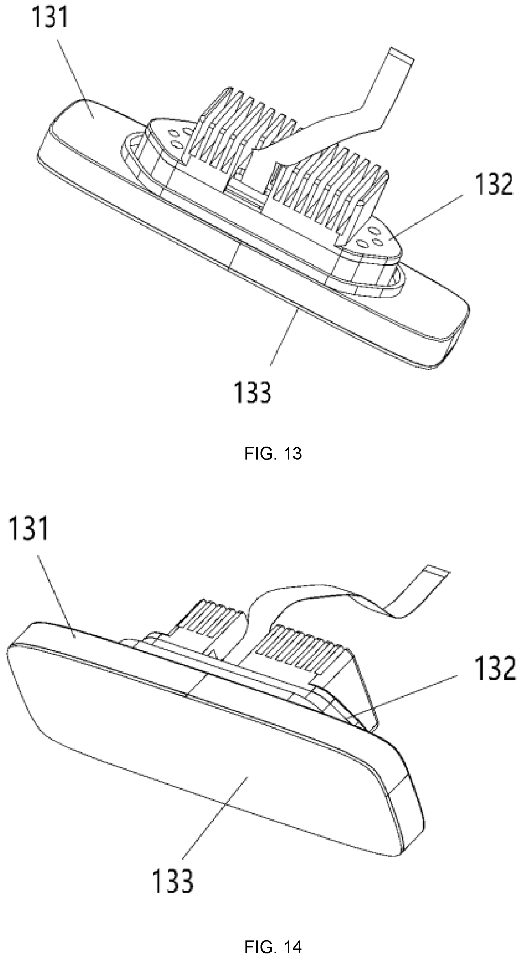

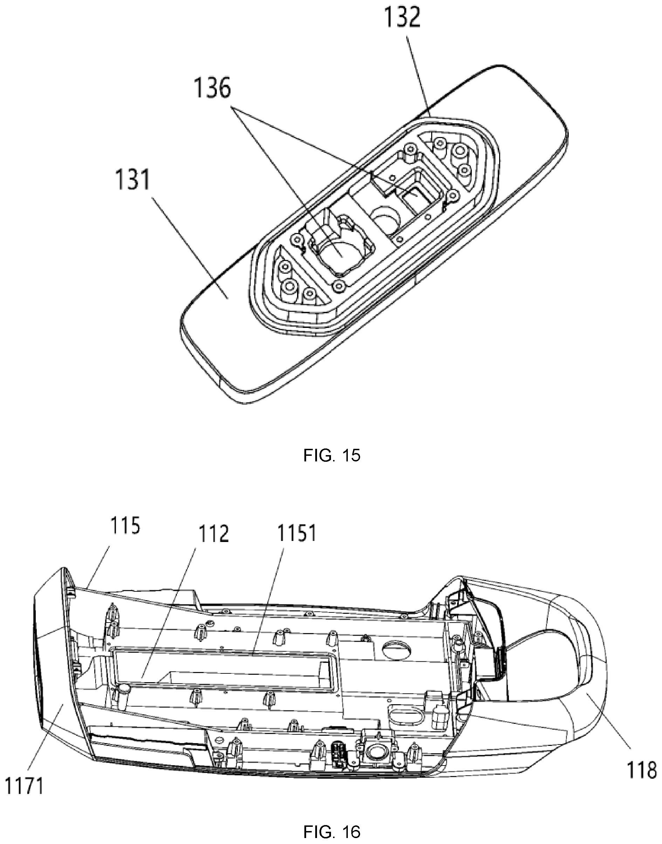

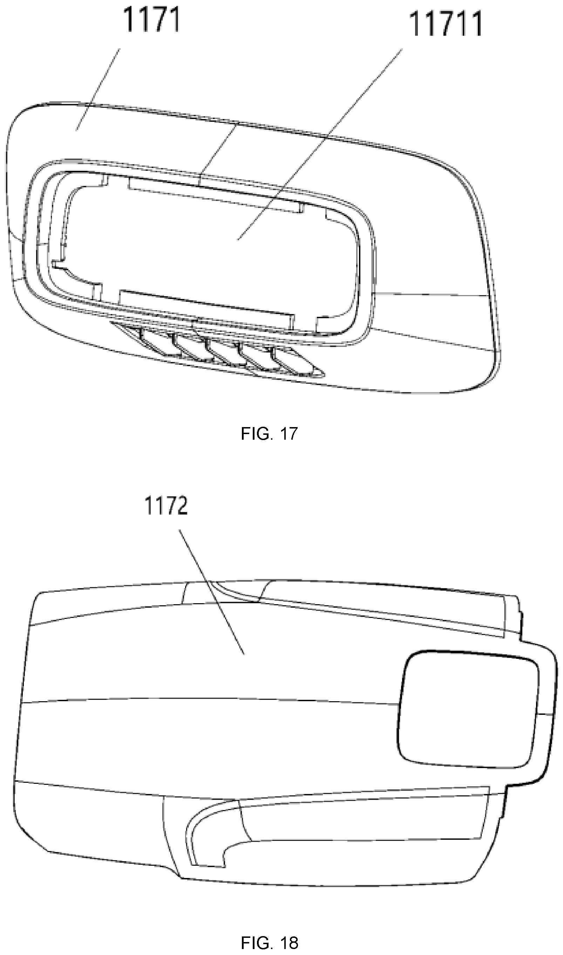

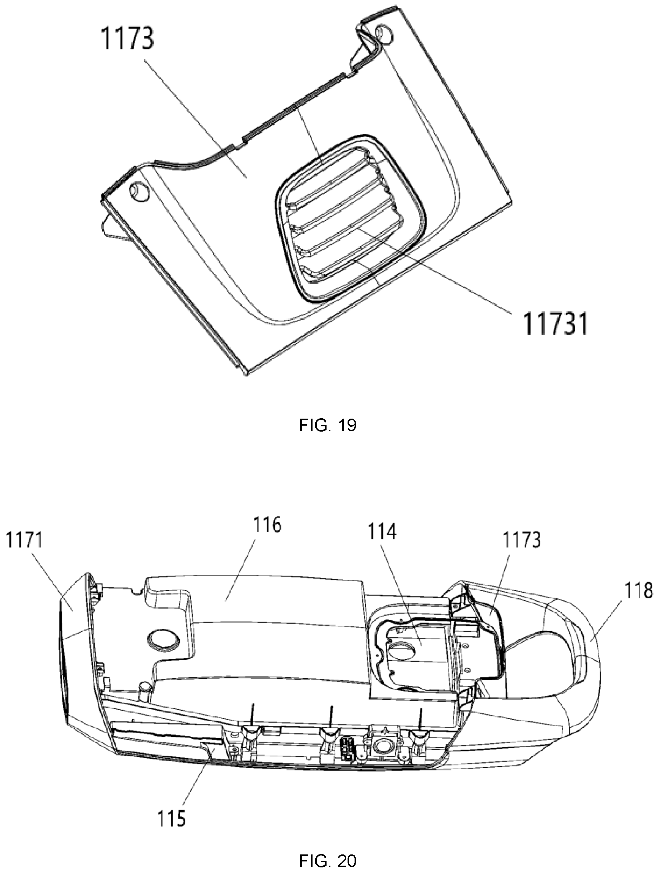

Therefore, embodiments of the present application provide a body. Referring to FIG. 1 to FIG. 23, the body includes a housing 11, a control board 12, a vision module 13, and a heat sink 14. A sealed cavity 111 is provided in the housing 11, and a heat dissipation channel 112 is further provided on the housing 11. The heat dissipation channel 112 communicates with the external environment and is independent of the sealed cavity 111. The control board 12 is provided in the sealed cavity 111 and is provided with an AI chip 121. The vision module 13 is provided on the housing 11, is at least partially located in the sealed cavity 111, and is electrically connected to the AI chip 121. The heat sink 14 is provided on the housing 11, part of the heat sink 14 is located in the sealed cavity 111, another part of the heat sink 14 is located in the heat dissipation channel 112, and the heat sink 14 is configured to dissipate heat from the AI chip 121.

When the vision module 13 is further provided on the housing 11, the vision module 13 is configured to collect environmental image information around the body in real time. The AI chip 121 processes the collected image information to identify an obstacle or a target object in the environment. When processing the image information collected by the vision module 13, the AI chip 121 generally needs to perform a large amount of computation, which may easily cause an excessively high surface temperature of the AI chip 121.

In the technical solution, the sealed cavity 111 and the heat dissipation channel 112 are provided on the housing 11 and are independent of each other. Electronic components such as the control board 12 can be mounted in the sealed cavity 111, and the electronic components such as the control board 12 are protected by the sealed cavity 111. The AI chip 121 is provided on the control board 12. When a large amount of computation by the AI chip 121 causes the surface temperature of the AI chip 121 to rise too quickly, the heat sink 14 is further provided to dissipate heat from the AI chip 121, thereby reducing the temperature of the AI chip 121. Specifically, a mounting position for the heat sink 14 is provided on the housing 11, and the heat sink 14 is fixed to the housing 11. One end of the heat sink 14 extends into the sealed cavity 111 to receive heat generated by electronic components having a large heat generation amount, such as the AI chip 121. The heat sink 14 may directly contact the AI chip 121 to transfer heat, or heat generated by the AI chip 121 during operation may be transferred to the heat sink 14 through a thermally conductive member such as a heat-conducting block. The heat sink 14 may even be spaced apart from the AI chip 121, so that heat dissipation from the AI chip 121 is indirectly achieved by dissipating heat from the sealed cavity 111 through the heat sink 14. Heat can be conducted in the heat sink 14, and another end of the heat sink 14 extends into the heat dissipation channel 112. The heat dissipation channel 112 communicates with the external environment, and gas flowing in the heat dissipation channel 112 can carry away heat from the heat sink 14, thereby continuously exchanging heat with the heat sink 14 and conducting heat in the AI chip 121 and the sealed cavity 111 to the outside of the housing 11 to reduce the temperatures of the AI chip 121 and the sealed cavity 111. In addition, because at least part of the vision module 13 is located in the sealed cavity 111, the housing 11 can protect the vision module 13 from water and sunlight, and the vision module 13 can be conveniently electrically connected to the control board 12 to implement data transmission and control.

In this embodiment, the sealed cavity 111 and the heat dissipation channel 112 that are independent of each other are provided on the housing 11. The sealed cavity 111 is configured to mount electronic components such as the control board 12. The heat sink 14 is further provided on the housing 11 to dissipate heat from the AI chip 121 and the sealed cavity 111. Part of the heat sink 14 is located in the sealed cavity 111 to receive heat from the AI chip 121 on the control board 12, and another part of the heat sink 14 is located in the heat dissipation channel 112 to exchange heat with external airflow, thereby conducting heat from the AI chip 121 to the external environment. This not only satisfies the sealing requirement for mounting the electronic components, but also solves the heat dissipation problem in the sealed cavity 111.

The heat sink 14 can be detachably connected to the housing 11 for easy maintenance.

The sealed cavity 111 can be arranged adjacent to the heat dissipation channel 112, and one end of the heat sink 14 can be arranged in the sealed cavity 111 to contact electronic components having high heat generation, such as the AI chip 121, for heat conduction.

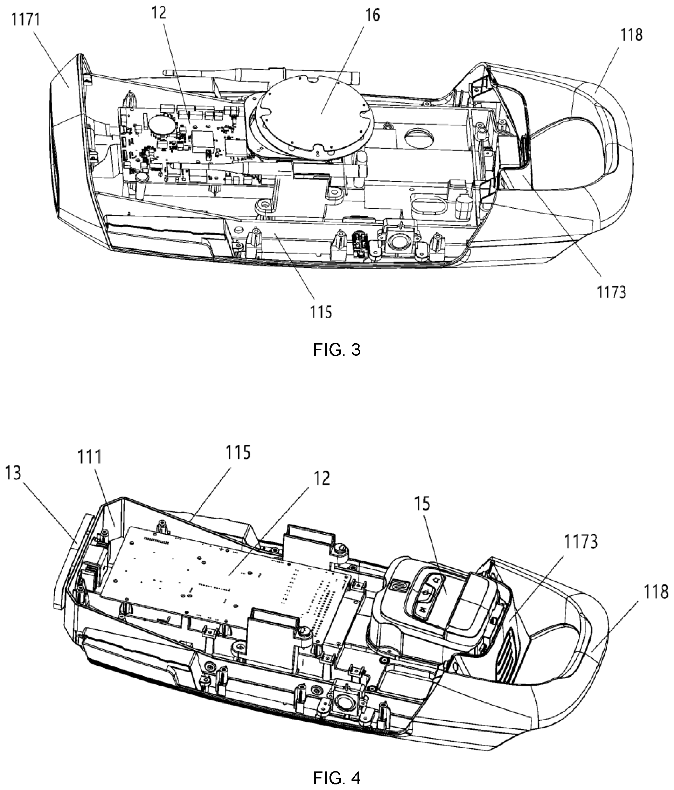

In an embodiment, referring to FIG. 3 to FIG. 8, the body further includes a positioning module 16. The positioning module 16 is provided in the sealed cavity 111. The positioning module 16 includes a positioning chip and a positioning antenna. The positioning antenna is electrically connected to the positioning chip, and the positioning chip is electrically connected to the AI chip 121.

Specifically, in the technical solution, the positioning module 16 may further be provided in the body. The positioning module 16 is electrically connected to the control board 12. The positioning module 16 is configured to obtain body position information, and the control board 12 controls movement of the body based on the position information. The positioning module 16 may include the positioning chip and the positioning antenna. The positioning antenna may receive satellite data, and the positioning chip may obtain the body position information by processing the satellite data received by the positioning antenna, and transmit the body position information to the AI chip 121 for computation, thereby implementing motion planning and control. In an embodiment, the positioning antenna is a real-time kinematic (RTK) antenna, and the positioning chip is a global positioning system (GPS) chip.

In this embodiment, the positioning module 16 is placed inside the sealed cavity 111, which protects the positioning module 16 from damage or malfunction that may occur if the positioning module 16 is exposed to the external environment, thereby improving the service life of the positioning module 16.

In an embodiment, the positioning chip is disposed on the control board 12, and the positioning antenna is disposed on the housing 11 and spaced apart from the control board 12.

Specifically, in the technical solution, the positioning chip is integrated on the control board 12 and can communicate with the AI chip 121 on the control board 12. The positioning antenna can be independently provided on the housing 11, and the satellite data acquired by the positioning antenna can be transmitted to the positioning chip. The positioning antenna can be provided on the top of the housing 11 to better receive signals and reduce signal interference.

In this embodiment, the positioning antenna is separated from the control board 12, which allows for independent maintenance of the positioning antenna, making maintenance convenient and reducing maintenance costs. The independently configured positioning antenna also reduces the component density of the control board 12, lowering the manufacturing difficulty and cost of the control board 12.

In an embodiment, the body further includes a communication module. The communication module is provided in the sealed cavity 111 and includes a communication board 124 and a communication antenna. A communication chip is provided on the communication board 124 and is electrically connected to the communication antenna and the AI chip 121.

Specifically, in the technical solution, the communication module is configured to implement communication between a base station and the control board 12. The communication module includes the communication board 124 and the communication antenna. The communication antenna is configured to receive a signal from the base station, and the communication chip provided on the communication board 124 is configured to process the signal. The communication chip is electrically connected to the positioning chip to implement data transmission between the communication chip and the positioning chip. The communication chip may receive data sent by the base station through the communication antenna, and send the data to the positioning chip. The positioning chip performs correction calculation together with the satellite data received by the positioning antenna to obtain more accurate body position information. In an embodiment, the communication chip is a Wi-Fi chip, and the communication antenna is a rubber rod antenna.

In this embodiment, the communication module is housed within the sealed cavity 111, which also prevents damage or malfunction caused by the communication module being exposed to a complex environment. The communication chip receives or transmits information through a communication antenna, and the communication chip is electrically connected to the AI chip 121, enabling information transmission between the communication chip and the AI chip 121.

In an embodiment, a communication board 124 is disposed on a control board 12, and the communication board 124 is located between the control board 12 and a heat sink 14, and the heat sink 14 is also configured to dissipate heat from the communication chip.

Specifically, in the technical solution, the communication board 124 is also provided on the control board 12. The communication board 124 is positioned close to the heat sink 14, and the communication chip on the communication board 124 is in contact with the heat sink 14. The heat sink 14 can conduct the heat of the communication chip to the outside of the housing 11, thereby achieving the purpose of heat dissipation for the communication chip.

In an embodiment, a communication antenna is disposed on the housing 11 and spaced apart from the communication board 124.

The communication antenna can be provided on the housing 11, independent of the communication board 124, and is electrically connected to the communication chip. The communication chip can receive or transmit information via the communication antenna. In an embodiment, the communication antenna can be provided on the top of the housing 11 for easy information reception or transmission.

In this embodiment, the communication antenna is spaced apart from the communication board 124, allowing for individual maintenance of the communication antenna, which is convenient and reduces maintenance costs. The independently positioned communication antenna also reduces the component density of the communication board 124, lowering its manufacturing difficulty and cost.

In an embodiment, referring to FIG. 1 to FIG. 11 and FIG. 20. The body also includes a button module 15. A second mounting opening 114 is provided on the housing 11. The button module 15 is installed at the second mounting opening 114 and the second mounting opening 114 is sealed. The control board 12 is electrically connected to the button module 15.

Specifically, in the technical solution, the button module 15 may further be provided on the body. The button module 15 is electrically connected to the control board 12, and one or more control functions may be implemented through the button module 15.

A second mounting opening 114 can be provided on the housing 11 for fixing the button module 15. The button module 15 is installed at the second mounting opening 114, and part of the button module 15 is outside the housing 11 for convenient button operation. A sealing structure or sealing gasket can be provided between the button module 15 and the second mounting opening 114 to keep the sealed cavity 111 and the button module 15 in a sealed state.

In an embodiment, the button module 15 may also be provided with a sealed structure to make the button module 15 waterproof and dustproof.

In this embodiment, the button module 15 is installed at the second mounting opening 114, and a sealing structure is formed between the button module 15 and the second mounting opening 114, which can prevent rainwater or dew from seeping into the housing 11 from the second mounting opening 114, thereby protecting the components inside the housing 11.

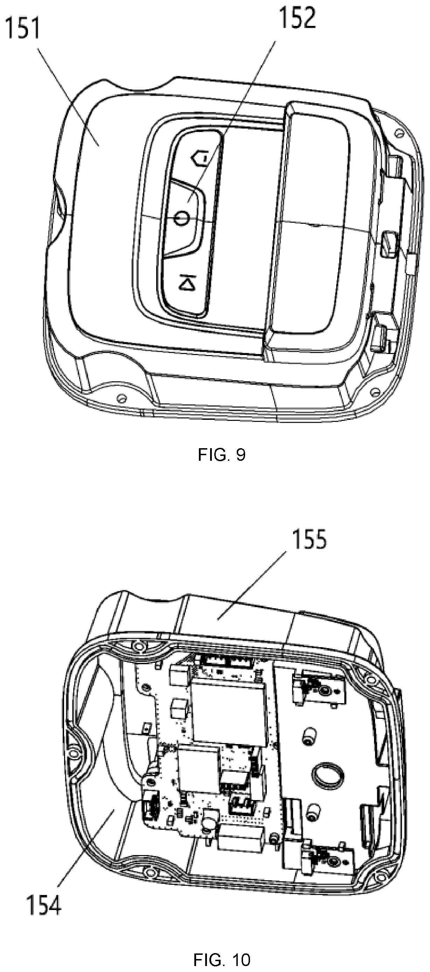

In an embodiment, referring to FIG. 9 to FIG. 11, the button module 15 includes: a mounting housing 151 connected to the housing 11, the mounting housing 151 having a first side 154 and a second side 155 distant from the first side 154, the first side 154 of the mounting housing 151 being the side facing the sealed cavity 111, and a through hole communicating with the first side 154 and the second side 155 of the mounting housing 151; and a function button assembly 152 including a button board 153, a flexible elastic sheet 159, and at least one first button, the elastic sheet 159 being fixed to the first side 154 of the mounting housing 151 and covering the through hole, the first button being provided on the elastic sheet 159 and movably passing through the through hole, the button board 153 being fixed to the first side 154 of the mounting housing 151 and located on the side of the elastic sheet 159 away from the mounting housing 151, the button board 153 being provided with a tact switch corresponding to the first button, and the button board 153 being electrically connected to the control board 12.

Specifically, in the technical solution, the mounting housing 151 connected to the housing 11 provides support for the function button assembly 152. The function button assembly 152 is mounted on the mounting housing 151, with a portion of the function button assembly 152 exposed outside the mounting housing 151. The inner surface of the mounting housing 151 corresponds to the first side 154, and the outer surface of the mounting housing 151 corresponds to the second side 155. The mounting housing 151 has through holes connecting the first side 154 and the second side 155. The first button in the function button assembly 152 passes through the through hole and is exposed outside the mounting housing 151. A flexible elastic sheet 159 is disposed on the first side 154 and covers the through hole. The first button can be mounted on the elastic sheet 159. The button board 153 is fixedly disposed on the first side 154 and located on the side of the elastic sheet 159 away from the through hole. The elastic sheet 159 is sealed around the through hole, and rainwater will be temporarily stored on the surface of the elastic sheet 159 facing the through hole, preventing rainwater from seeping into the button board 153.

In an embodiment, the function button assembly 152 may include one or more first buttons, which may be various types of keys such as a power button, a start button, or a charging button. The elastic sheet 159 may be a silicone sheet or a rubber sheet. The button board 153 is disposed on one side of the elastic sheet 159 and may be in a pressing contact with the elastic sheet 159 or spaced apart from the elastic sheet 159. When the button board 153 is in a pressing contact with the elastic sheet 159, the elastic sheet 159 is sandwiched between the mounting housing 151 and the button board 153, which can seal the edge of the through hole.

In this embodiment, the flexible elastic sheet 159 serves as a sealing element, which can prevent water passing through the through hole from seeping into the button board 153, thereby ensuring the safety of the button board 153. By setting the flexible elastic sheet 159 to cover the through hole and setting the button board 153 on the side away from the housing, rainwater or dew is prevented from seeping into the mounting housing 151 through the through hole and continuing to reach the button board 153, and the problem of the button board 153 of the button module 15 being soaked by rainwater or dew is solved.

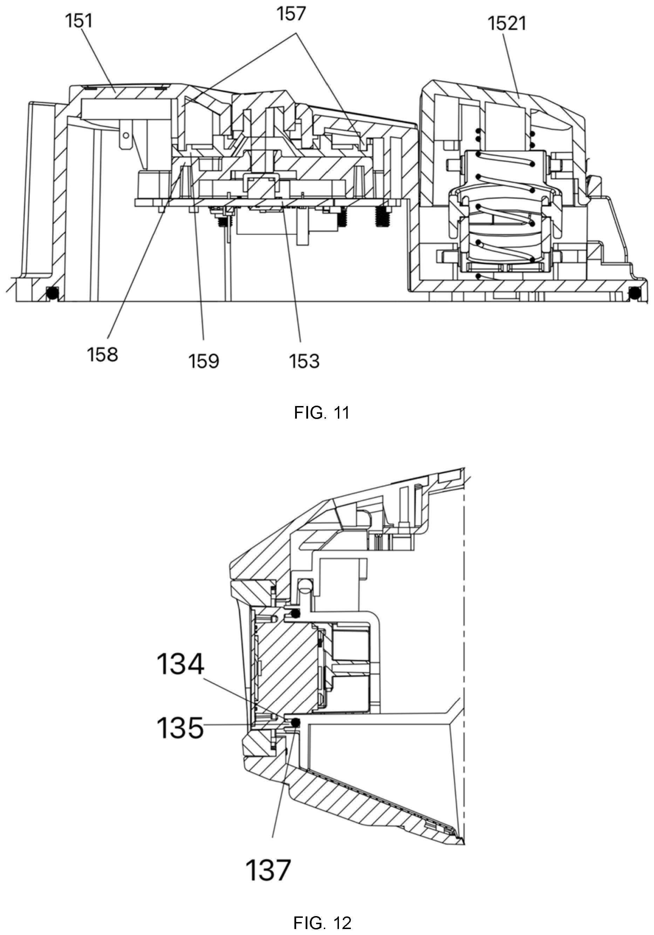

In an embodiment, referring to FIG. 11, the first side 154 of the mounting housing 151 is provided with an annular rib 157 that surrounds the through hole. The function button assembly 152 also includes a support member 158. The support member 158 is fixed on the mounting housing 151 and located between the elastic sheet 159 and the button board 153. The elastic sheet 159 is clamped between the support member 158 and the annular rib 157.

Specifically, in the technical solution, the support member 158 provides support for the elastic sheet 159. The support member 158 can be a support plate or a support frame. The support member 158 is fixedly connected to the mounting housing 151, and the elastic sheet is clamped between the support member 158 and the annular rib 157 surrounding the through hole, thereby sealing the through hole. The button board 153 is located at the end of the support member 158 away from the elastic sheet.

In this embodiment, by providing an annular rib 157 and a support member 158, the elastic sheet 159 is clamped between the annular rib 157 and the support member 158, so that the elastic sheet 159 and the annular rib 157 enclose a water storage space, temporarily storing water in the water storage space to prevent water from seeping into the button board 153.

In an embodiment, as shown in FIG. 11, the function button assembly 152 also includes an emergency stop switch 1521 for controlling the robot to stop in an emergency.

In an embodiment, referring to FIG. 1, FIG. 4 to FIG. 7, FIG. 12 to FIG. 15, and FIG. 21, a first mounting opening 113 is provided on the housing 11. The vision module 13 is installed in the first mounting opening 113 and the first mounting opening 113 is sealed. A part of the vision module 13 is located outside the sealed cavity 111, and another part is located inside the sealed cavity 111.

Specifically, in the technical solution, a vision module 13 can also be provided on the housing 11. The vision module 13 can be used to acquire images around the housing. The vision module 13 is electrically connected to the control board 12. The vision module 13 can transmit the acquired images to the AI chip 121 on the control board 12, where the AI chip 121 processes them and controls movement of the body and the operation of various functional modules based on the processing results. The vision module 13 can also preprocess the acquired raw images, including but not limited to decoding, image stretching, image size adjustment, and correction.

A first mounting opening 113 can be provided on the housing 11, and the vision module 13 can be installed in the first mounting opening 113. In an embodiment, a part of the vision module 13 is located on one side of the first mounting opening 113, and another part of the vision module 13 is located on the other side of the first mounting opening 113. The first mounting opening 113 provides support for the vision module 13.

In this embodiment, the first mounting opening 113 may be provided on the housing 11 for mounting the vision module 13. The vision module 13 is fixed through the first mounting opening 113, and is partially provided in the first cavity, thereby facilitating connection between the vision module 13 and the control board 12 and preventing excessively rapid temperature rise caused by sunlight irradiation.

In an embodiment, referring to FIG. 12 to FIG. 15, the vision module 13 includes a mounting base and a camera disposed within the mounting base. The mounting base includes a first mounting portion 131 and a second mounting portion 132. The first mounting portion 131 and the second mounting portion 132 are arranged in a stepped manner and projected along a first direction. The projected area of the first mounting portion 131 is larger than the projected area of the second mounting portion 132. The first direction is the direction from the first mounting portion 131 to the second mounting portion 132. The second mounting portion 132 extends into the sealed cavity 111 through a first mounting opening 113. The first mounting portion 131 abuts against the side surface of the housing 11 distant from the sealed cavity 111.

Specifically, in the technical solution, a portion of the vision module 13 is located outside the housing 11, while another portion is located inside the sealed cavity 111 of the housing 11. Therefore, the mounting base for the vision module 13 is stepped, including a first mounting portion 131 and a second mounting portion 132. The outline of the first mounting portion 131 is larger than that of the second mounting portion 132. The first mounting portion 131 is located outside the housing 11, and the second mounting portion 132 is located inside the housing 11. A first mounting opening 113 is provided on the housing 11, connecting the sealed cavity 111 with the external space of the housing 11. The outline of the first mounting opening 113 matches that of the second mounting portion 132, and the second mounting portion 132 is inserted into the first mounting opening 113 and placed inside the sealed cavity 111. Because the outline of the first mounting portion 131 is larger than that of the second mounting portion 132, the first mounting portion 131 abuts against the edge of the first mounting opening 113 outside the housing 11. Simultaneously, the edge of the first mounting opening 113 provides support for the mounting base.

In an embodiment, the camera is fixed within the mounting cavity 136 on the mounting base. A portion of the mounting base is located on one side of the first mounting opening 113, and another portion is located on the other side of the first mounting opening 113, which supports the mounting base. A viewing window 11711 corresponding to the vision module 13 can also be provided on the housing 11 to prevent the housing 11 from obstructing the image acquisition by the vision module 13. The viewing window 11711 corresponds to the camera of the vision module 13. In an embodiment, the camera lens does not protrude from the viewing window 11711, and a lens 133 can be provided on the mounting base to protect the camera lens. The lens 133 can be a transparent lens, and its material can be glass or acrylic.

In this embodiment, the first mounting portion 131 and the second mounting portion 132, which are arranged in a stepped manner, cooperate with the housing 11. Specifically, the first mounting portion 131 abuts against the outer surface of the housing 11, and the second mounting portion 132 extends into the mounting opening and is fitted with the mounting opening with a clearance. The housing 11 has a limiting support function for the mounting base, which can make the mounting base stably connected to the housing 11. At the same time, it can also prevent water vapor, impurities, etc. from entering the sealed cavity 111 through the mounting opening.

In an embodiment, referring to FIG. 12, an abutment rib 135 is provided on one side surface of the first mounting portion 131, the abutment rib 135 surrounds the second mounting portion 132, and a slot 134 is provided on a surface of the housing 11 distant from the sealed cavity 111. The slot 134 surrounds the first mounting opening 113. A first sealing ring 137 is mounted in the slot 134, and the abutment rib 135 is inserted into the slot 134 and abuts against the first sealing ring 137.

Specifically, in the technical solution, one side of the first mounting portion 131 is the side close to the second mounting portion 132. The abutment rib 135 is arranged on the first mounting portion 131 around the outline of the second mounting portion 132. When the second mounting portion 132 is inserted into the first mounting opening 113 on the housing 11, the abutment rib 135 directly abuts against the periphery of the first mounting opening 113. The abutment rib 135 is in close contact with the housing 11 so as to seal the first mounting portion 131 and the housing 11.

Specifically, in the technical solution, a slot 134 is provided around the first mounting opening 113 on the outer surface of the housing 11. A first sealing ring 137 is provided inside the slot 134. The slot 134 is matched with an abutment rib 135. The abutment rib 135 is inserted into the slot 134 and abuts against the first sealing ring 137. The abutment rib 135 and the slot 134 form a sealing structure for sealing between the housing 11 and the mounting base.

In this embodiment, the abutment rib 135 surrounding the second mounting portion 132 is inserted into the slot 134 provided on the surface of the housing 11, and a sealing ring is provided in the slot 134 to improve the sealing around the first mounting opening 113; at the same time, the slot 134 can also limit the mounting base to prevent the vision module 13 from shifting.

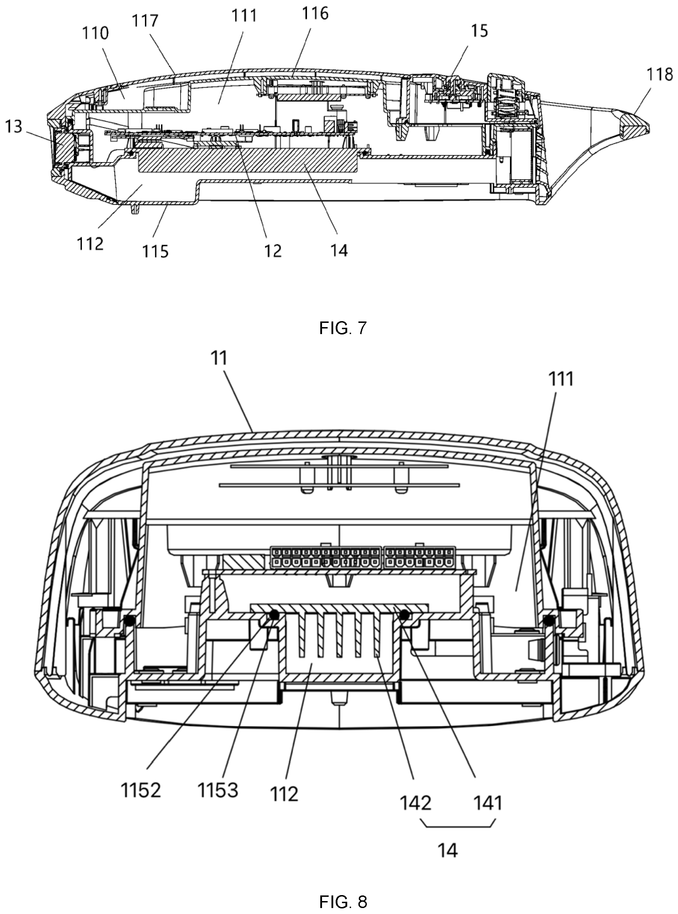

In an embodiment, referring to FIG. 7 and FIG. 8, the housing 11 includes a bottom shell 115 and an upper shell 116. The upper shell 116 is mounted on the bottom shell 115 and cooperates with the bottom shell 115 to define a sealed cavity 111. The housing 11 also includes a decorative shell 117, which covers the upper shell 116 and is fixed on the bottom shell 115. The decorative shell 117, the upper shell 116, and the bottom shell 115 cooperate to define a heat-insulating cavity 110.

Specifically, in the technical solution, the housing 11 includes a bottom shell 115, an upper shell 116, and a decorative shell 117. The upper shell 116 is mounted on the bottom shell 115, and the space formed by the upper shell 116 and the bottom shell 115 is referred to as the sealed cavity 111. The control board 12 is installed inside the sealed cavity 111. In an embodiment, the upper shell 116 is smaller in profile than the bottom shell 115, and the upper shell 116 is installed inside the bottom shell 115. The decorative shell 117 covers the upper shell 116, and the decorative shell 117 is spaced apart from the upper shell 116. The decorative shell 117 is fixed to the bottom shell 115, and the upper shell 116 is located within the space formed by the decorative shell 117 and the bottom shell 115. The space formed by the upper shell 116, the decorative shell 117, and the bottom shell 115 is referred to as the heat-insulating cavity 110. The main function of the heat-insulating cavity 110 is to insulate against direct sunlight, preventing the upper shell 116 from being exposed to direct sunlight and causing the temperature inside the sealed cavity 111 to rise. It should be understood that the heat-insulating cavity 110 is formed by the outer surface of the upper shell 116, the inner surface of the decorative shell 117, and the inner surface of the bottom shell 115.

The shape and size of the sealed cavity 111 can be matched to the components installed inside. The space inside the sealed cavity 111 can be regular or irregular. To further reduce the temperature inside the sealed cavity 111, a heat dissipation device can be installed inside the sealed cavity 111 to achieve the purpose of cooling. The heat dissipation device can include heat dissipation fins that are in direct contact with the external environment, and heat exchange with the external environment through the heat dissipation fins. This keeps the temperature inside the sealed cavity 111 within a low threshold, ensuring the normal operation of electronic components such as the control board 12 inside the sealed cavity 111.

In an embodiment, referring to FIG. 2, the bottom shell 115 also includes a speaker 119 and a programming port 120. The speaker 119 and programming port 120 are connected to the control board 12 via wires. The speaker 119 is used to play sound. The programming port 120 is connected to an external device. The speaker 119 and programming port 120 can be disposed in the heat-insulating cavity 110.

In an embodiment, as shown in FIG. 2, the bottom shell 115 also includes a handle 118, which includes a first sub-part and a second sub-part. The first sub-part is integrally formed with the bottom shell 115, and the second sub-part is connected to the first sub-part. The edge of the decorative shell 117 is aligned with the edge of the second sub-part.

In this embodiment, a handle 118 is provided for easy hand support or carrying. The first sub-part is integrally formed with the bottom shell 115, which can improve the structural strength of the handle 118.

In an embodiment, as shown in FIG. 3 to FIG. 6 and FIG. 17 to FIG. 19, the decorative shell 117 includes a front decorative shell 1171, a middle decorative shell 1172, and a rear decorative shell 1173. The front decorative shell 1171 is disposed at one end of the bottom shell 115, the rear decorative shell 1173 is disposed at the other end of the bottom shell 115, and the middle decorative shell 1172 is disposed in the middle of the bottom shell 115. The front decorative shell 1171, the middle decorative shell 1172, and the rear decorative shell 1173 are connected in sequence.

The front decorative shell 1171 can be provided with a viewing window 11711 corresponding to the vision module 13. The middle decorative shell 1172 can be configured as a U-shaped structure. The rear decorative shell 1173 can be provided with louvers 11731 for ventilation and heat dissipation. The front decorative shell 1171, middle decorative shell 1172, and rear decorative shell 1173 can all be detachably connected to the bottom shell 115 for easy maintenance.

In this embodiment, the housing 11 is composed of three independent parts, namely the bottom shell 115, the upper shell 116, and the decorative shell 117, to define two independent cavities. The heat-insulating cavity 110 surrounds the sealed cavity 111. The sealed cavity 111 is configured to mount components such as the control board 12, and the heat-insulating cavity 110 is configured for heat insulation, thereby overcoming the problem that the temperature in the sealed cavity 111 rises sharply due to direct sunlight on the housing 11.

In an embodiment, the heat dissipation channel 112 includes an air inlet and an air outlet. The air inlet is located at the front end of the housing 11, the air outlet is located at the rear end of the housing 11, and the heat dissipation channel 112 is a straight channel.

Specifically, in the technical solution, the air inlet is located at the front end of the heat dissipation channel 112, where the front end refers to the end of the heat dissipation channel 112 facing the forward direction of the housing 11. The air outlet is located at the rear end of the heat dissipation channel 112, where the rear end refers to the end of the heat dissipation channel 112 facing the backward direction of the housing 11. When moving forward, as air flows from the front to the rear of the housing 11, some air will flow in through the air inlet of the heat dissipation channel 112 and out through the air outlet. The faster the forward speed, the higher the airflow velocity within the heat dissipation channel 112, and the better the heat exchange effect of the heat sink 14 within the heat dissipation channel 112.

The heat dissipation channel 112 may extend through the housing 11. In this case, the air inlet of the heat dissipation channel 112 is located at the front end of the housing 11, and the air outlet of the heat dissipation channel 112 is located at the rear end of the housing 11. Providing the heat dissipation channel 112 through the housing 11 allows for simultaneous cooling of other functional modules arranged on the heat dissipation channel 112, making full use of space. The heat dissipation channel 112 can also be provided only near the sealed cavity 111 to cool only the control board 12 within the sealed cavity 111.

In an embodiment, the heat dissipation channel 112 can be configured as a straight channel. A straight channel has lower airflow resistance, faster airflow velocity, and a larger airflow rate per unit time through the heat dissipation channel 112, resulting in higher heat exchange efficiency.

In this embodiment, the air inlet of the heat dissipation channel 112 is located at the front end of the housing 11, the air outlet of the heat dissipation channel 112 is located at the rear end of the housing 11, and the heat dissipation channel 112 is configured as a straight channel, which is more conducive to air circulation. As the robot continues to move forward, air continuously enters the heat dissipation channel 112 from the front end of the housing and flows out of the heat dissipation channel 112 from the rear end of the housing, promoting the flow of gas in the heat dissipation channel 112 and improving heat dissipation efficiency.

In an embodiment, a filter screen is provided inside the heat dissipation channel 112.

Specifically, in the technical solution, the filter screen may be provided at any position in the heat dissipation channel 112 as needed. The filter screen can be provided at the air inlet. The number of filter screens provided in the heat dissipation channel 112 can be one or more, and the filter pore size can also be selected as needed. When multiple filters are placed, a combination of filters with different pore sizes can also be selected.

In this embodiment, the filter screen is configured to filter out objects such as leaves and plant debris that may enter and block the heat dissipation channel 112, thereby ensuring smooth airflow in the heat dissipation channel 112.

In an embodiment, a fan is provided inside the heat dissipation channel 112 to accelerate the flow of gas inside the heat dissipation channel 112.

In an embodiment, the fan can be an axial flow fan. The fan can be placed at any position in the heat dissipation channel 112 according to the actual situation. One or more fans may be provided. It is understood that when multiple fans are provided, the airflow directions should be configured to be the same.

Turning on the fan can increase the flow velocity of gas entering the heat dissipation channel 112, thereby improving the heat exchange efficiency between the airflow and the heat sink 14.

In an embodiment, referring to FIG. 7, FIG. 8, FIG. 16, and FIG. 21, a third mounting opening 1151 is provided on the housing 11, and the heat sink 14 is mounted on the third mounting opening 1151. The heat sink 14 includes an integrally formed contact plate 141 and heat dissipation fins 142. The contact plate 141 is located in the sealed cavity 111 and blocks the third mounting opening 1151. The heat dissipation fins 142 extend into the heat dissipation channel 112 through the third mounting opening 1151. The contact plate 141 contacts the AI chip 121.

Specifically, in the technical solution, the third mounting opening 1151 is used to mount the heat sink 14. The heat dissipation fins 142 of the heat sink 14 pass through the third mounting opening 1151 and extend into the heat dissipation channel 112. The contact plate 141 of the heat sink 14 seals the third mounting opening 1151 and is fixed at the third mounting opening 1151. The contact plate 141 seals the third mounting opening 1151, and the control board 12 inside the sealed cavity 111 can contact the contact plate 141 to dissipate heat from the control board 12. The shape and size of the third mounting opening 1151 can be matched to the contour of the heat sink 14.

In an embodiment, a third mounting opening 1151 is provided on the housing 11. The sealed cavity 111 and the heat dissipation channel 112 are arranged adjacent to each other. The third mounting opening 1151 is located on the wall shared by the sealed cavity 111 and the heat dissipation channel 112. When the heat sink 14 is not installed, the sealed cavity 111 and the heat dissipation channel 112 can communicate through the third mounting opening 1151. When the heat sink 14 is installed, the heat dissipation fins 142 of the heat sink 14 extend into the heat dissipation channel 112 from the third mounting opening 1151. The contact plate 141 of the heat sink 14 is located in the sealed cavity 111 and blocks the third mounting opening 1151. It is understood that the contact plate 141 completely covers the third mounting opening 1151. The contact plate 141 can be detachably fixed to the third mounting opening 1151 by bolt connection, which facilitates the disassembly and maintenance of the heat sink 14. After the heat sink 14 is fixed, the contact plate 141 directly contacts the AI chip 121 or other heat-generating components on the control board 12 to conduct heat from the AI chip 121 or other heat-generating components. The heat is conducted through the contact plate 141 to the heat dissipation fins 142, and then exchanged with the external airflow through the heat dissipation fins 142 in the heat dissipation channel 112 to achieve the purpose of heat dissipation.

In this embodiment, the third mounting opening 1151 is used to mount the heat sink 14. The heat dissipation fins 142 of the heat sink 14 pass through the third mounting opening 1151 and extend into the heat dissipation channel 112. The contact plate 141 of the heat sink 14 seals the third mounting opening 1151 and is fixed at the third mounting opening 1151. The contact plate 141 seals the third mounting opening 1151 and contacts the AI chip 121 to dissipate heat from the AI chip 121. The heat sink 14 can keep the sealed cavity 111 in a sealed state and achieve heat dissipation for the AI chip 121. The structure is simple and easy to maintain.

In an embodiment, referring to FIG. 8, a second sealing ring 1153 is provided around the third mounting opening 1151, and the second sealing ring 1153 is clamped between the contact plate 141 and the housing 11.

The present embodiment can further improve the sealing effect between the contact plate 141 and the housing by providing a second sealing ring 1153.

In an embodiment, referring to FIG. 8, a receiving groove 1152 is provided around the third mounting opening 1151, and a second sealing ring 1153 is received in the receiving groove 1152. The opening of the receiving groove 1152 faces into the sealed cavity 111, and the receiving groove 1152 is located at the edge of the third mounting opening 1151 and surrounds the third mounting opening 1151. The second sealing ring 1153 is disposed in the receiving groove 1152, and the second sealing ring 1153 is pressed against the contact plate 141 of the heat sink 14 for sealing between the contact plate 141 and the third mounting opening 1151. The size of the receiving groove 1152 can be matched according to the size of the second sealing ring 1153. It should be understood that the depth of the receiving groove 1152 is less than the height of the second sealing ring 1153 after being pressed.

The present embodiment uses a receiving groove 1152 to limit and fix the second sealing ring 1153, overcoming the problem that the second sealing ring 1153 may be misaligned during installation, affecting the sealing effect or causing sealing failure.

In an embodiment, a thermally conductive adhesive layer is provided between the contact plate 141 and the AI chip 121.

The thermally conductive adhesive layer provided between the contact plate 141 and the AI chip 121 can alleviate the problem of poor heat conduction caused by the gap between the AI chip 121 and the contact plate 141.

In an embodiment, a thermally conductive adhesive layer is provided between the contact plate 141 and the AI chip 121. The thermally conductive adhesive layer has good thermal conductivity and can be made of thermally conductive adhesive. When the contact plate 141 and the AI chip 121 (or other heat-generating elements) have poor contact, the thermally conductive adhesive can be applied to enable good contact between the contact plate 141 and the AI chip 121 (or other heat-generating elements), thereby improving the thermal conductivity efficiency.

In this embodiment, a thermally conductive adhesive layer is provided between the contact plate 141 and the AI chip 121 to improve the thermal conductivity and overcome the problem of poor heat conduction caused by gaps or poor contact between the AI chip 121 and the contact plate 141.

In an embodiment, a heat-conducting block may be provided between the contact plate 141 and the AI chip 121, and a thermally conductive adhesive layer may be provided between the heat-conducting block and the contact plate 141, and between the heat-conducting block and the AI chip 121. A heat-conducting block may also be provided between the contact plate 141 and the AI chip 121 (or other heat-generating elements) for heat conduction. The heat-conducting block has good thermal conductivity and is typically made of a metal material with high thermal conductivity. In an embodiment, there is a gap between the AI chip 121 (or other heat-generating element) and the contact plate 141, and a heat-conducting block is used to connect the contact plate 141 and the AI chip 121 (or other heat-generating element) so that the heat generated by the AI chip 121 (or other heat-generating element) during operation can be transferred to the heat sink 14.

In an embodiment, a thermally conductive adhesive layer can be provided between the AI chip 121 (or other heat-generating element) and the heat-conducting block. The thermally conductive adhesive layer has good thermal conductivity and can be made of thermally conductive adhesive. When the heat-conducting block and the AI chip 121 (or other heat-generating element) have poor contact, the thermally conductive adhesive can be applied to enable the heat-conducting block and the AI chip 121 (or other heat-generating element) to make good contact and improve the heat conduction efficiency.

In an embodiment, the heat dissipation fins 142 can be integrally formed with the contact plate 141. Multiple heat dissipation fins 142 can be provided, increasing the heat dissipation area of the heat sink 14 and improving heat dissipation efficiency. The multiple heat dissipation fins 142 can be arranged in parallel, with the same distance between any adjacent fins. The multiple heat dissipation fins 142 can be elongated, and their extending direction can be the same as the extending direction of the heat dissipation channel 112. This aims to reduce airflow resistance within the heat dissipation channel 112, increase airflow velocity, and thus improve the heat exchange efficiency of the heat dissipation fins 142 within the heat dissipation channel 112. The heat dissipation fins 142 can be rectangular in shape.

This embodiment increases the heat dissipation area by providing multiple heat dissipation fins 142, thereby improving the heat dissipation effect of the heat sink 14. The extension direction of the heat dissipation fins 142 is consistent with the extension direction of the heat dissipation channel 112 in order to reduce the airflow resistance flowing through the heat dissipation channel 112, increase the airflow velocity, and thus improve the heat exchange efficiency of both the airflow and the heat sink 14.

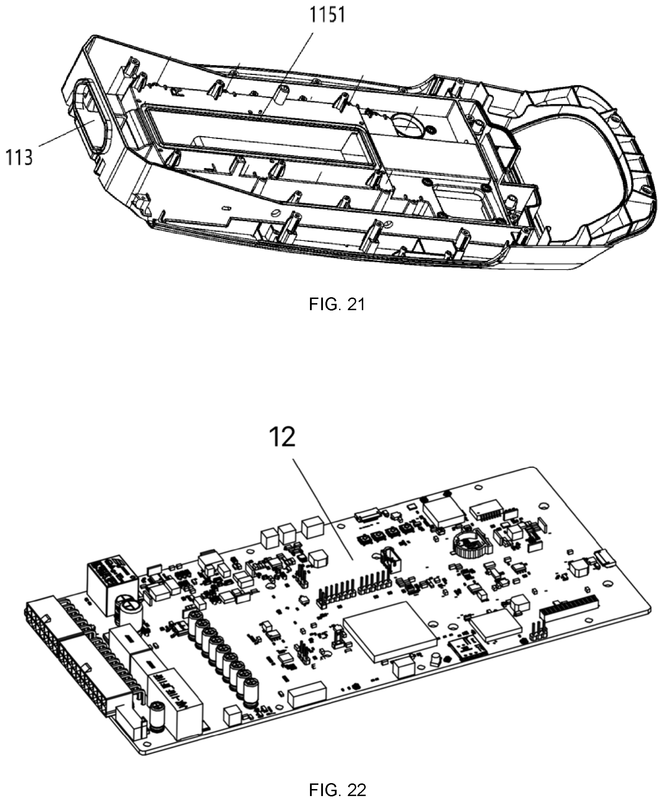

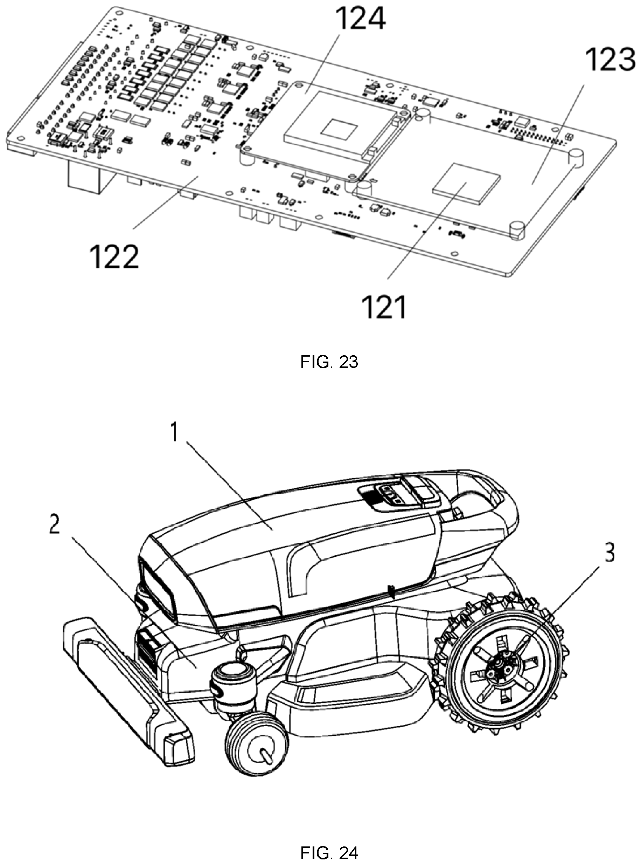

In an embodiment, referring to FIG. 22 and FIG. 23, the control board 12 includes a base board 122 and a core board 123. The core board 123 is detachably mounted on the base board 122, and the base board 122 and the core board 123 transmit signals through a connector. The AI chip 121 is mounted on the core board 123. The AI chip 121 includes a CPU and also includes an NPU and/or a GPU.

Specifically, in the technical solution, the base board 122 is a printed circuit board with various basic functional modules and external interfaces. The core board 123 is a circuit board integrating an AI computing module. The connection between the core board 123 and the base board 122 enables one or more specific functions. The core board 123 can be electrically connected to the base board 122 via a connector to achieve signal transmission between the core board 123 and the base board 122.

In this embodiment, the core board 123 and the base board 122, which are equipped with AI chip 121, are configured as two independent circuit boards. The core board 123 and the base board 122 are electrically connected through a connector. The core board 123 and the connector are detachably connected. The function settings of the control board 12 are very flexible, and the processing and maintenance are simple and convenient, which can reduce production costs.

The base board 122 serves as a basic board, providing interfaces for various functional modules. With the continuous development of electronic technology, the number of layers and component density on printed circuit boards are constantly increasing, while trace spacing is gradually decreasing. This makes signal integrity a crucial consideration in digital circuit system design. Higher printed circuit board density increases the likelihood of signal transmission interference, which negatively impacts the performance and stability of the electronic system. This embodiment of the present application addresses the problems of excessive component density and difficult trace design on the base board 122 by independently configuring the base board 122 and core board 123.

In addition to a CPU, the AI chip 121 may further include one or more of an NPU and a GPU. A central processing unit (CPU) is an important component in a computer system, is located on a computer mainboard, and is configured to execute instructions and control computer operations while undertaking many operation and computation tasks. A neural processing unit (NPU) is an embedded neural network processor specially designed for deep neural network computation, and is usually used in artificial intelligence, machine learning, natural language processing, and other scenarios. A graphics processing unit (GPU) is a processor specially used for efficiently processing images and graphics, and GPUs are widely used in scientific computing, computer vision, deep learning, graphics rendering, and other fields.

In this embodiment, the AI chip 121 may include one or more chips such as an NPU or GPU, in addition to a CPU. These chips can be integrated as needed to achieve multiple functions, thus improving the practicality of the control board 12.

Embodiments of the present application also provide a robot, including the body as described above.

This embodiment adopts the body described above. The sealed cavity 111 for mounting the control board 12 and the heat dissipation channel 112 are provided independently on the housing 11, and the heat sink 14 is provided on the housing 11. Part of the heat sink 14 is located in the sealed cavity 111 and is configured to receive heat from the AI chip 121 on the control board 12. The heat can be conducted in the heat sink 14. Another part of the heat sink 14 is located in the heat dissipation channel 112 and exchanges heat with external airflow, thereby conducting heat from the AI chip 121 to the external environment and dissipating heat from the AI chip 121. This embodiment satisfies waterproof and dustproof requirements in the sealed cavity 111, and also alleviates the problem of temperature rise caused by heat generation of the AI chip 121.

Embodiments of the present application further provide a robot system. Referring to FIG. 24, the robot system includes a first body 1 and at least one second body 2 detachably connectable to the first body 1. The first body 1 is the body described above.

In this embodiment, the robot system includes at least two bodies, with the first body 1 being the aforementioned body. The first body 1 includes an independently configured sealed cavity 111 and a heat dissipation channel 112. The sealed cavity 111 is used to install electronic components, and a heat sink 14 is provided on the housing 11. The control board 12 is placed inside the sealed cavity 111. Part of the heat sink 14 is located inside the sealed cavity 111 and is used to receive heat from the AI chip 121 on the control board 12. The heat can be conducted through the heat sink. Another part of the heat sink 14 is located inside the heat dissipation channel 112 and exchanges heat with the external airflow, thereby conducting the heat from the AI chip 121 to the external environment. This not only meets the sealing requirements for the installation of electronic components but also solves the heat dissipation problem within the sealed cavity 111.

In an embodiment, the first body 1 further includes the heat-insulating cavity 110. Electronic components are mounted in the sealed cavity 111, and the heat-insulating cavity 110 is configured for heat insulation, thereby overcoming the problem that the temperature in the sealed cavity 111 rises sharply due to sunlight irradiation.

In an embodiment, the first body 1 and the second body 2 are distributed vertically, and the second body 2 is provided with a walking mechanism 3 and a functional mechanism.

Specifically, in the technical solution, the robot system includes two vertically distributed bodies. The sealed cavity 111 and the heat dissipation channel 112 are provided in the higher first body 1 to prevent excessive debris from entering the heat dissipation channel 112, ensure smooth airflow, and reduce the influence of rainwater and dew on the sealed cavity 111. The lower second body 2 may be provided with the walking mechanism 3 and the functional mechanism. The walking mechanism 3 pulls the robot to travel on the ground, and the functional mechanism performs an operation on the ground, such as cutting, cleaning, or polishing. In this manner, the first body 1 functions as a brain of the robot system, the second body 2 functions as limbs of the robot system, and the first body 1 controls operation of the second body 2.

In an embodiment, the robot system has at least two second bodies 2, each with different functional mechanisms, including at least one of a cutting mechanism, a cleaning mechanism, and a polishing mechanism. The robot system includes multiple second bodies 2, each of which can be equipped with different functional mechanisms, such as cutting, cleaning, and polishing mechanisms. It can be understood that when the functional mechanism is a cutting mechanism, the robot is a lawnmower robot; when the functional mechanism is a cleaning mechanism, the robot is a cleaning robot. Generally, different functional mechanisms result in different functions for the corresponding second bodies 2.

In this embodiment, by providing the robot system to include a first body 1 and multiple second bodies 2 with different functional mechanisms, the first body 1 can be connected and combined with the second bodies 2 with different functions as a common control platform to obtain robots with different functions.

The above descriptions are merely embodiments of the present application and are not intended to limit the present application. Modifications, equivalent substitutions, improvements, and the like made based on the disclosure of the present application are intended to fall within the scope of the present application.

## Claims

1. A body, **characterized by** comprising:
a housing, wherein a sealed cavity is provided in the housing, a heat dissipation channel is provided on the housing, and the heat dissipation channel communicates with an external environment and is independent of the sealed cavity;
a control board provided in the sealed cavity, wherein an artificial intelligence (AI) chip is provided on the control board;
a vision module provided on the housing, wherein at least part of the vision module is located in the sealed cavity, and the vision module is electrically connected to the AI chip; and
a heat sink provided on the housing, wherein part of the heat sink is located in the sealed cavity, another part of the heat sink is located in the heat dissipation channel, and the heat sink is configured to dissipate heat from the AI chip.

2. The body according to claim 1, further comprising a positioning module provided in the sealed cavity, wherein the positioning module comprises a positioning chip and a positioning antenna, the positioning antenna is electrically connected to the positioning chip, and the positioning chip is electrically connected to the AI chip.

3. The body according to claim 2, wherein the positioning chip is provided on the control board, and the positioning antenna is provided on the housing and spaced apart from the control board.

4. The body according to claim 2, further comprising a communication module provided in the sealed cavity, wherein the communication module comprises a communication board and a communication antenna, a communication chip is provided on the communication board, the communication chip is electrically connected to the communication antenna, and the communication chip is electrically connected to the AI chip.

5. The body according to claim 4, wherein the communication board is provided on the control board, the communication board is located between the control board and the heat sink, and the heat sink is further configured to dissipate heat from the communication chip; and/or the communication antenna is provided on the housing and spaced apart from the communication board.

6. The body according to claim 1, further comprising a button module, wherein a second mounting opening is provided on the housing, the button module is mounted at the second mounting opening and blocks the second mounting opening, and the control board is electrically connected to the button module.

7. The body according to claim 6, wherein the button module comprises:
a mounting housing connected to the housing, wherein the mounting housing has a first side and a second side distant from the first side, the first side of the mounting housing faces the sealed cavity, and the mounting housing is provided with a through hole communicating the first side and the second side of the mounting housing; and
a function button assembly comprising a button board, a flexible elastic sheet, and at least one first button, wherein the elastic sheet is fixed to the first side of the mounting housing and covers the through hole, the first button is provided on the elastic sheet and movably inserted through the through hole, the button board is fixed to the first side of the mounting housing and located on a side of the elastic sheet away from the mounting housing, the button board is provided with a tact switch corresponding to the first button, and the button board is electrically connected to the control board.

8. The body according to claim 7, wherein an annular rib surrounding the through hole protrudes from the first side of the mounting housing, the function button assembly further comprises a support member, the support member is fixed to the mounting housing and located between the elastic sheet and the button board, and the elastic sheet is clamped between the support member and the annular rib.

9. The body according to claim 1, wherein a first mounting opening is provided on the housing, the vision module is mounted in the first mounting opening and blocks the first mounting opening, part of the vision module is located outside the sealed cavity, and another part of the vision module is located in the sealed cavity.

10. The body according to claim 9, wherein the vision module comprises:
a mounting base and a camera provided in the mounting base, wherein the mounting base comprises a first mounting portion and a second mounting portion, the first mounting portion and the second mounting portion are arranged in a stepped manner, a projected area of the first mounting portion along a first direction is greater than a projected area of the second mounting portion along the first direction, the first direction is a direction from the first mounting portion toward the second mounting portion, the second mounting portion extends into the sealed cavity through the first mounting opening, and the first mounting portion abuts against a surface of the housing distant from the sealed cavity.

11. The body according to claim 10, wherein an abutment rib is provided on one side surface of the first mounting portion, the abutment rib surrounds the second mounting portion, a slot is provided on a surface of the housing distant from the sealed cavity, the slot surrounds the first mounting opening, a first sealing ring is mounted in the slot, and the abutment rib is inserted into the slot and abuts against the first sealing ring.

12. The body according to any one of claims 1 to 11, wherein the housing comprises a bottom shell and an upper shell, and the upper shell is mounted on the bottom shell and cooperates with the bottom shell to define the sealed cavity;
the housing further comprises a decorative shell, wherein the decorative shell covers the upper shell and is fixed to the bottom shell, and the decorative shell, the upper shell, and the bottom shell cooperate to define a heat-insulating cavity.

13. The body according to any one of claims 1 to 11, wherein the heat dissipation channel comprises an air inlet and an air outlet, the air inlet is provided at a front end of the housing, the air outlet is provided at a rear end of the housing, and the heat dissipation channel is a straight channel.

14. The body according to any one of claims 1 to 11, wherein a filter screen is provided in the heat dissipation channel; and/or a fan is provided in the heat dissipation channel, and the fan is configured to accelerate flow of gas in the heat dissipation channel.

15. The body according to any one of claims 1 to 11, wherein a third mounting opening is provided on the housing, and the heat sink is mounted at the third mounting opening; the heat sink comprises an integrally formed contact plate and heat dissipation fins, the contact plate is located in the sealed cavity and blocks the third mounting opening, the heat dissipation fins extend into the heat dissipation channel from the third mounting opening, and the contact plate contacts the AI chip.

16. The body according to claim 15, wherein a second sealing ring is provided around the third mounting opening, and the second sealing ring is clamped between the contact plate and the housing; and/or a thermally conductive adhesive layer is provided between the contact plate and the AI chip.

17. The body according to any one of claims 1 to 11, wherein the control board comprises a base board and a core board, the core board is detachably provided on the base board, and the base board and the core board transmit signals through a connector; the AI chip is provided on the core board, the AI chip comprises a central processing unit (CPU), and the AI chip further comprises a neural processing unit (NPU) and/or a graphics processing unit (GPU).

18. A robot, **characterized by** comprising the body according to any one of claims 1 to 17.

19. A robot system, **characterized by** comprising a first body and at least one second body detachably connectable to the first body, wherein the first body is the body according to any one of claims 1 to 17.

20. The robot system according to claim 19, wherein the first body and the second body are distributed vertically, and the second body is provided with a walking mechanism and a functional mechanism; at least two second bodies are provided, the functional mechanisms on different second bodies are different, and the functional mechanisms comprise at least one of a cutting mechanism, a cleaning mechanism, and a polishing mechanism.
